# EUROPÄISCHE PATENTANMELDUNG

(11) **EP 2 741 591 A1**
(43) Veröffentlichungstag der Anmeldung: **11.06.2014**
(21) Anmeldenummer: 13193771.6
(22) Anmeldetag: 21.11.2013
(51) Int. Cl.: H05K 1/02, H05K 3/12, H05K 3/24, H05K 3/34

(54) **Verfahren zur Herstellung einer Leiterplatte mit erhöhter Stromtragfähigkeit**

(30) Priorität: 10.12.2012 DE 102012222678
(71) Anmelder: ROBERT BOSCH GMBH, 70442 Stuttgart (DE)
(72) Erfinder: Vogelgesang, Michael, 70565 Stuttgart (DE)

(57) **Zusammenfassung**

Verfahren zum Herstellen einer Leiterplatte (1), umfassend die Schritte Bereitstellen eines Substrats (2), Vorsehen von zumindest einer Leiterbahn (31) und zumindest einer Anschlussfläche (32) auf dem Substrat (2), und Aufbringen zumindest eines ersten Lots (42) und zumindest einer elektronischen Komponente (5) auf die Anschlussfläche (32), gekennzeichnet dadurch, dass auf oder an zumindest einen Teil der Leiterbahn (31) ein zweites Lot (41) aufgebracht wird, und das erste Lot (42) auf der Anschlussfläche (32) und das zweite Lot (41) auf der Leiterbahn (32) gemeinsam bis mindestens zu einem Schmelzpunkt des ersten Lots (42) und des zweiten Lots (41) erhitzt wird, wobei ein Querschnitt von zumindest einem Bereich der Leiterbahn (31) durch das zweite Lot (41) vergrößert wird.

## Beschreibung

### Stand der Technik

Die vorliegende Erfindung betrifft ein Verfahren zum Herstellen einer Leiterplatte. Insbesondere betrifft die Erfindung ein Verfahren zum Herstellen einer Leiterplatte, die eine erhöhte Stromtragfähigkeit gegenüber herkömmlichen Leiterplatten aufweisen soll.

In vielen Steuergeräten werden hohe Ströme verarbeitet. Dies führt dazu, dass die entsprechenden Leiterbahnen einen großen Kupferquerschnitt benötigen. Als Stand der Technik wird derzeit eine Erhöhung des Leiterbahnquerschnitts durch Verbreiterung der Leiterbahnen, dickere Kupferlagen, Nutzen mehrerer Kupferlagen oder durch Stromschienen erreicht. Diese genannten Möglichkeiten wirken sich jedoch signifikant auf die Fertigungstechnik, Zuverlässigkeit und die Leiterplattenpreise aus.

### Offenbarung der Erfindung

Das erfindungsgemäße Verfahren zum Herstellen einer Leiterplatte mit den Merkmalen des Anspruchs 1 umfasst die folgenden Schritte: Zunächst wird ein Substrat bereitgestellt. Bei dem Substrat kann es sich beispielsweise um eine Trägerplatte handeln, die bevorzugt aus einem Kunststoff gefertigt ist. Beispielsweise kann ein Epoxidharz verwendet werden. Anschließend werden auf das Substrat zumindest eine Leiterbahn und zumindest eine Anschlussfläche, z.B. in Form eines Footprint oder eines (Copper-)Land, aufgebracht. Dabei dient die zumindest eine Leiterbahn bevorzugt zum Verbinden von mehreren Anschlussflächen, während die zumindest eine Anschlussfläche zur Verbindung mit einer elektronischen Komponente vorgesehen ist. Im nächsten Schritt wird ein erstes Lot und zumindest eine elektrische Komponente auf die Anschlussfläche aufgebracht. Dieser Schritt entspricht dem Bestücken der Leiterplatte mit Bauteilen. Erfindungsgemäß wird ebenso ein zweites Lot auf oder an zumindest einen Teil der Leiterbahn aufgebracht. Anschließend wird sowohl das erste Lot auf der Anschlussfläche als auch das zweite Lot auf oder an der Leiterbahn gemeinsam bis mindestens zu einem Schmelzpunkt des ersten Lots und des zweiten Lots erhitzt. Dies führt bevorzugt dazu, dass sich einerseits das erste Lot auf der Anschlussfläche fest mit der elektronischen Komponente und mit der Anschlussfläche selbst verbindet. So entsteht eine sichere elektrische Verbindung zwischen Anschlussfläche und elektronischem Bauteil. Andererseits wird das auf die Leiterbahn aufgebrachte zweite Lot fest mit der Leiterbahn verbunden. Außerdem ist bevorzugt vorgesehen, dass sich das zweite Lot auf oder an der Leiterbahn vollständig auf die Leiterbahn zurückzieht. So kann beispielsweise auch zweites Lot teilweise neben der Leiterbahn angebracht werden, da dieses aufgrund der Nichthaftung auf dem Substrat während des Erhitzens zu der Leiterbahn fließt. Als Resultat wird daher der Querschnitt der Leiterbahn in dem zumindest einem Bereich durch das zweite Lot vergrößert. Dies hat vorteilhafter Weise zur Folge, dass die Stromtragfähigkeit der Leiterbahn ebenfalls gesteigert wird. Durch die erfindungsgemäße Integration des Erhöhens des Querschnitts der Leiterbahn in den Lötprozess, mit dem elektrische Komponenten auf der Leiterplatte angebracht werden, ergeben sich sowohl zeitliche als auch finanzielle Vorteile bei der Fertigung der Leiterplatte. Das erfindungsgemäße Verfahren ermöglicht daher ein einfaches und kostengünstiges Herstellen von Leiterplatten mit erhöhter Stromtragfähigkeit.

Das erfindungsgemäße Verfahren kann beispielsweise auch angewandt werden, um Leiterplatten zu modifizieren. In diesem Fall würde eine Leiterplatte bereitgestellt, die Substrat, Leiterbahnen, Anschlussflächen und auch bereits elektronische Komponenten umfassen kann. Auf diese Weise kann die Stromtragfähigkeit von bestehenden Leiterplatten vorteilhaft verbessert werden.

Die Unteransprüche zeigen bevorzugte Weiterbildungen der Erfindung.

Bevorzugt ist vorgesehen, dass das erste Lot und/oder das zweite Lot in Form einer Lötpaste auf die Anschlussflächen und/oder auf die Leiterbahn aufgebracht wird. Bei der Verwendung von Lötpaste zum Verbinden der Anschlussfläche mit der elektronischen Komponente ist es insbesondere vorteilhaft, wenn die Lötpaste eine klebende Eigenschaft aufweist. Die Verwendung der Lötpaste für das Aufbringen des zweiten Lots auf die Leiterbahn hat den Vorteil, dass dieselbe Lötpaste wie zur Kontaktierung der elektronischen Komponenten verwendet werden kann. Somit wird der Schritt des Aufbringens des ersten Lots und des zweiten Lots auf die Leiterplatte deutlich vereinfacht, da hier nicht unterschieden werden muss, ob die Lötpaste auf die Anschlussfläche oder auf die Leiterbahn aufgebracht werden muss.

In einer vorteilhaften Ausführungsform der Erfindung wird ein Lötstopplack auf die Leiterbahnen und/oder auf das Substrat aufgebracht. Insbesondere in Verbindung mit der Lötpaste verhindert der Lötstopplack, dass ungewollte Kontaktierungen von Leiterbahn und/oder Anschlussfläche und/oder elektronischer Komponente erzeugt werden. Außerdem werden die Leiterbahnen und die Leiterplatte vor mechanischen Einflüssen geschützt.

Besonders vorteilhaft ist vorgesehen, dass der Lötstopplack vor dem Aufbringen des zweiten Lots auf den zumindest einen Bereich der Leiterbahn wieder entfernt wird. In diesem Fall ist die Leiterbahn einerseits durch den Lötstopplack, andererseits durch das aufgetragene zweite Lot vor äußeren Einflüssen geschützt. Weiterhin erlaubt das selektive Entfernen des Lötstopplacks ein Aufbringen des zweiten Lots lediglich an definierten Stellen der Leiterbahn.

In vorteilhafter Weise wird das zweite Lot auf die Leiterbahn über ein Lotdepot aufgebracht. Insbesondere bei einem großflächigen Auftrag von zweitem Lot auf die Leiterbahn kann die Verwendung beispielsweise von großflächig aufgetragener Lotpaste nachteilig sein. Die Verwendung eines Lotdepots kann daher vorteilhaft sein, wenn eine große Fläche der Leiterbahn mit zweitem Lot bedeckt werden soll.

Besonders vorteilhaft umfasst das Lotdepot ein mit zweitem Lot gefülltes Gitter, wobei das Gitter eine Vielzahl von einzelnen Lotspeichern definiert. Beispielsweise kann das Lotdepot in eine Schablone eingebracht sein, die für den Auftrag des ersten Lots und/oder des zweiten Lots auf die Leiterplatte verwendet wird. Dies kann beispielsweise auch eine einstückige Ausbildung des Lotdepots mit der Schablone umfassen. Auf diese Weise wird eine größtmögliche Menge von zweitem Lot innerhalb des Lotdepots gespeichert wobei das Gitter für eine großflächige Verteilung des zweiten Lots sorgt. Dies ermöglicht in sehr einfacher Weise das großflächige Auftragen von zweitem Lot auf die Leiterbahn.

Durch das Gitter wird außerdem sichergestellt, dass der Lotauftrag homogen erfolgt. Dabei kann sich das zweite Lot aus dem Lotdepot während des Erhitzens bevorzugt zu einer geschlossenen Lotfläche verbinden. Alternativ ist ebenso bevorzugt vorgesehen, dass das zweite Lot aus dem Lotdepot während des Erhitzens einzelne Flächen bildet, die nicht zu einer geschlossenen Lotfläche zusammengeführt sind.

Besonders bevorzugt sind die Lotspeicher kreisförmig oder polygonförmig ausgebildet und gemäß der Theorie der dichtesten Packung angeordnet. In diesem Fall wird eine größtmögliche Menge an Lotspeichern auf der Leiterplatte vorgesehen, sodass ebenso eine größtmögliche Menge an zweitem Lot aufgetragen werden kann. Gemäß der Anordnung der dichtesten Packung ist eine sehr einfache Methode verfügbar, mit der die Lotspeicher innerhalb des Gitters angeordnet werden können.

Ebenso bevorzugt ist vorgesehen, dass die Lotspeicher Geometrien aufweisen, die durch Voronoi Tesselation bzw. Dirichlet Zerlegung erzeugt werden. Dies erlaubt beispielsweise eine Gewichtung von Orten, an denen bevorzugt zweites Lot auf die Leiterbahn aufgebracht werden soll.

In einer vorteilhaften Weise wird als Lotdepot eine vordefinierte Lotdepotvorlage verwendet. Diese Lotdepotvorlage wird bevorzugt auf den zumindest ein Bereich der Leiterbahn angepasst, beispielsweise durch Ausschneiden aus der Lotdepotvorlage. Alternativ kann ein Lotdepot direkt für den zumindest einen Bereich der Leiterbahn erstellt werden. Die erste Alternative erlaubt sehr vorteilhaft die Verwendung vorgefertigter Lotdepots, die auf unterschiedlichste Leiterbahngeometrien angepasst werden können. Dahingegen erlaubt die zweite Alternative das individuelle und damit materialschonende Erstellen eigener Lotdepots für jeden spezifischen Anwendungsfall. Dies kann gerade bei Großserien vorteilhaft sein.

In einer bevorzugten Ausführungsform der Erfindung wird das zweite Lot derart auf die Leiterbahn aufgebracht, dass die Fläche des Querschnitts der Kombination aus zweitem Lot und Leiterbahn zumindest das Eineinhalbfache der Fläche des Querschnitts der Leiterbahn beträgt. Insbesondere ist vorgesehen, dass die Fläche des Querschnitts der Kombination aus zweitem Lot und Leiterbahn zumindest das Zweifache der Fläche des Querschnitts der Leiterbahn beträgt. Mit einer derartigen Erhöhung des Querschnitts der Leiterbahn kann die Stromtragfähigkeit der Leiterplatte signifikant erhöht werden. So kann beispielsweise bei einer Verdoppelung des Querschnitts die Stromtragfähigkeit verdoppelt werden.

### Kurze Beschreibung der Zeichnungen

Nachfolgend werden Ausführungsbeispiele der Erfindung unter Bezugnahme auf die begleitende Zeichnung im Detail beschrieben. In den Zeichnungen ist:
- Figur 1: eine schematische Darstellung einer Leiterplatte vor und nach der Durchführung des Verfahrens gemäß einem ersten Ausführungsbeispiel der Erfindung,
- Figur 2: eine schematische Darstellung einer Leiterplatte vor und nach dem Durchführen eines Verfahrens gemäß einem zweiten Ausführungsbeispiel der Erfindung,
- Figur 3: die schematische Darstellung einer Lotdepotvorlage, wie sie für die Durchführung des erfindungsgemäßen Verfahrens gemäß einer dritten bevorzugten Ausführungsform verwendet wird,
- Figur 4: eine Leiterbahn, die mit dem Verfahren gemäß dem dritten Ausführungsbeispiel der Erfindung behandelt wurde,
- Figur 5: ein Lotdepot, dass in dem erfindungsgemäßen Verfahren gemäß einer vierten Ausführungsform verwendet wird, und
- Figur 6: eine schematische Darstellung einer Leiterplatte, die mit dem Verfahren gemäß einer fünften Ausführungsform der Erfindung behandelt wurde.

### Ausführungsformen der Erfindung

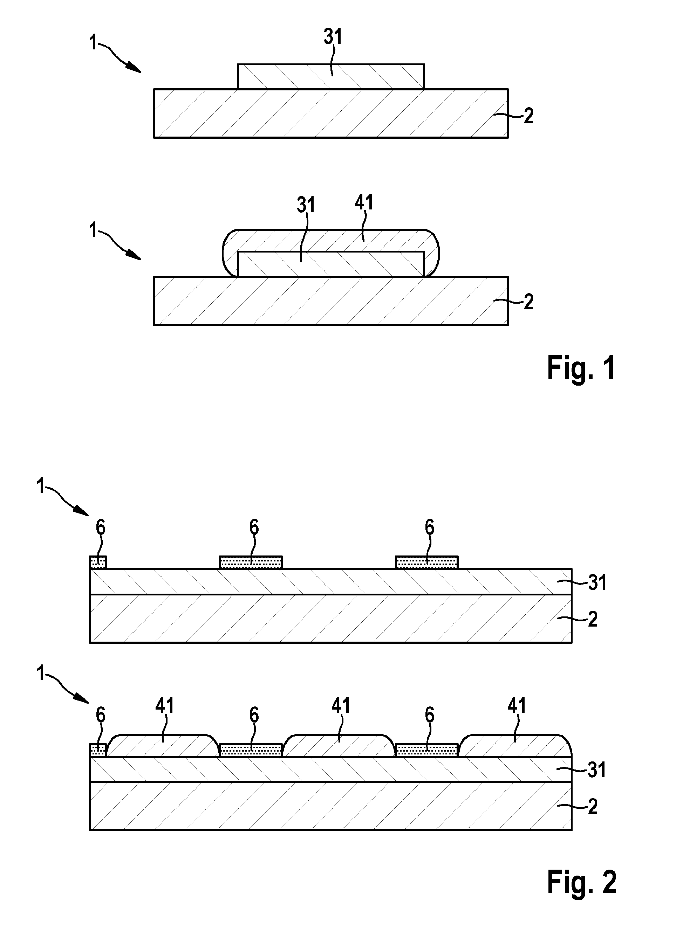

In Figur 1 ist eine Leiterplatte 1 gezeigt, die ein Substrat 2 und eine Leiterbahn 31 umfasst. Wird diese Leiterplatte 1 mit dem erfindungsgemäßen Verfahren gemäß einer ersten Ausführungsform behandelt, so wird auf die Leiterbahn 31 eine Schicht aus einem zweiten Lot 41 aufgebracht. Das zweite Lot 41 verdoppelt somit den Querschnitt der Leiterbahn, wodurch sich die Stromtragfähigkeit der Leiterbahn ebenfalls verdoppelt. Dies kann beispielsweise lokal an einzelnen Stellen der Leiterplatte durchgeführt werden.

Figur 2 zeigt das großflächige Aufbringen von zweitem Lot 41 auf eine Leiterplatte 1. Dies entspricht einer zweiten Ausführungsform des erfindungsgemäßen Verfahrens. Wiederum umfasst die Leiterplatte 1 ein Substrat 2 und eine Leiterbahn 31, wobei die Leiterbahn 31 teilweise von einem Lötstopplack 6 bedeckt ist. Auf die freien Stellen der Leiterbahn 31 wird ein zweites Lot 41 aufgetragen, das bis zu seinem Schmelzpunkt erhitzt wird, um dieses fest mit der Leiterbahn 31 zu verbinden. Daher weist die Leiterplatte 1 nach Durchführung des erfindungsgemäßen Verfahrens gemäß der zweiten Ausführungsform an den Bereichen der Leiterbahn 31, die nicht von dem Lötstopplack 6 bedeckt waren, eine Lotschicht 41 auf. Alternativ wäre es möglich, zur Erzielung des gleichen Resultats das zweite Lot 41 derart auf die Leiterbahn 31 aufzubringen, dass dieses auch über den Lötstopplack 6 reicht und so den Lötstopplack 6 bedeckt. Bei Anwendung des erfindungsgemäßen Verfahrens gemäß der zweiten Ausführungsform zieht sich während des Schritts des Erhitzens das zweite Lot 41 von dem Lötstopplack 6 vollständig auf die Leiterbahn 31 zurück.

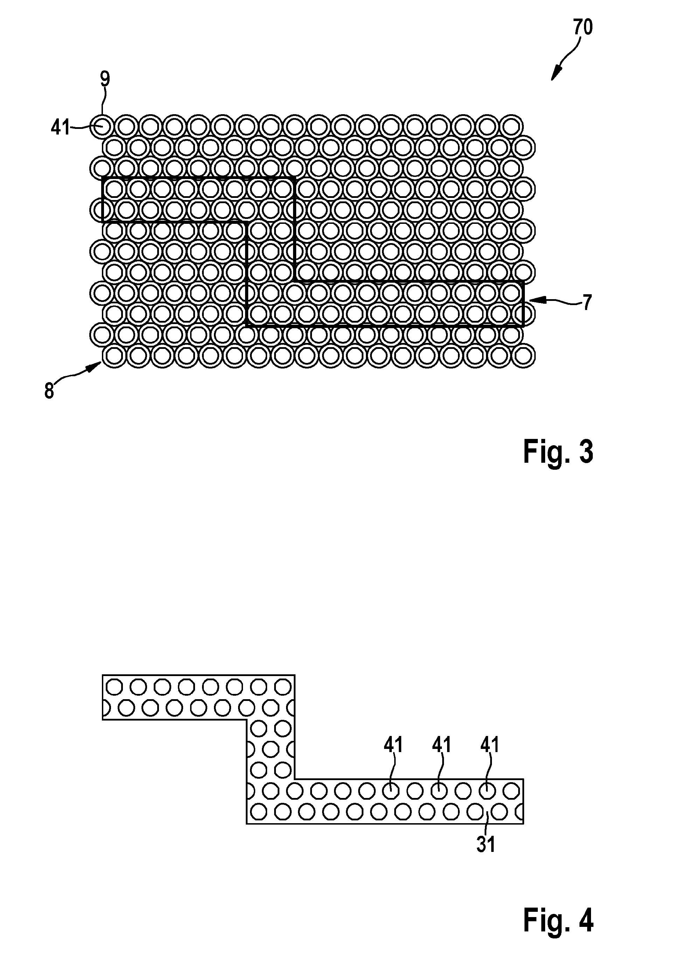

Während in dem in Figur 1 gezeigten Beispiel lediglich lokal zweites Lot 41 auf die Leiterbahn 31 aufgebracht wurde, was das lokale Auftragen einer Lotpaste auf die Leiterbahn 31 erlaubt, zeigt das Beispiel aus Figur 2 das großflächige Auftragen von zweitem Lot 41 auf die Leiterbahn 31. Für dieses großflächige Auftragen wird ein Lotdepot benötigt, dessen Verwendung in den folgenden drei Figuren 3 bis 5 gezeigt ist.

Figur 3 zeigt eine Lotdepotvorlage 70 die in einem dritten Ausführungsbeispiel des erfindungsgemäßen Verfahrens verwendet wird. Die Lotdepotvorlage 70 umfasst ein Gitter 8, dass eine Vielzahl von Lotspeichern 9 umfasst, wobei die Lotspeicher 9 mit einem zweiten Lot 41 gefüllt sind. Aus dieser Lotdepotvorlage 70 wird ein Lotdepot 7 ausgeschnitten, sodass das Lotdepot 7 ebenfalls ein Gitter 8 und die Vielzahl von Lotspeichern 9 umfasst, wobei die Lotspeicher 9 mit Lot 41 gefüllt sind. Dieses Lotdepot 7 kann nun verwendet werden, um großflächig Lot auf eine Leiterbahn 31 aufzutragen. Dieser Fall ist in Figur 4 dargestellt.

Figur 4 zeigt einen Zwischenstatus in dem erfindungsgemäßen Verfahren gemäß der dritten Ausführungsform, bei dem zweites Lot 41 über das Lotdepot 7 auf die Leiterbahn 31 aufgebracht wurde. Wie aus Figur 4 ersichtlich, ist das zweite Lot 41 großflächig über die Leiterbahn 31 verteilt. Erfindungsgemäß wird das zweite Lot 41 in einem weiteren Schritt bis zum Schmelzpunkt des zweiten Lots 41 erhitzt, sodass dieses eine homogene Oberfläche auf der Leiterbahn 31 bildet. Dies wird durch die bereits anfänglich homogene Verteilung des zweiten Lots 41 durch das Lotdepot 7 begünstigt.

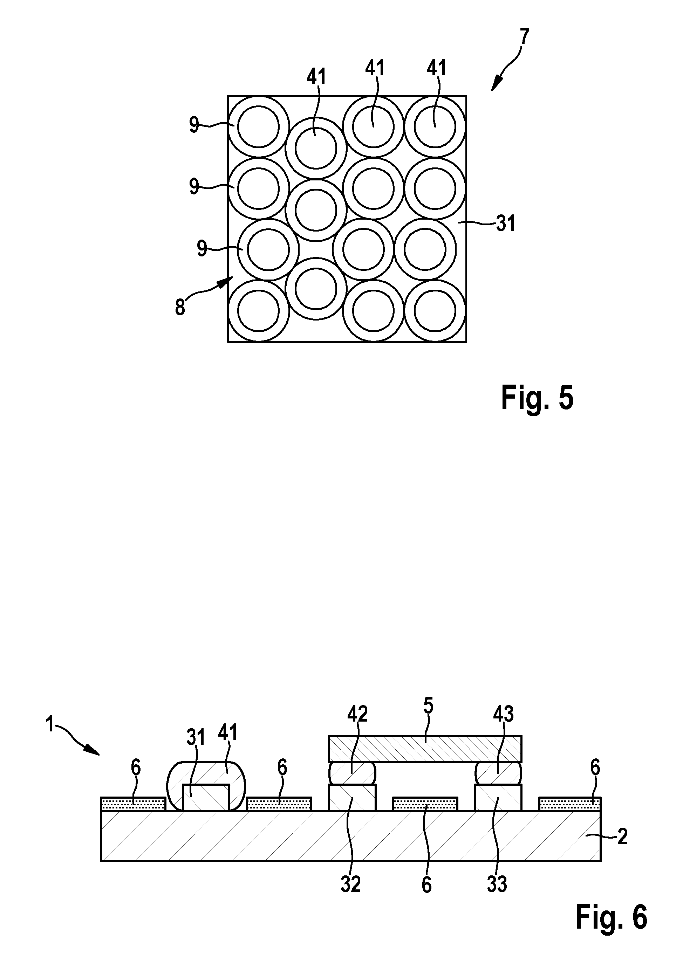

Figur 5 zeigt eine Alternative zu dem zuvor beschriebenen Verfahren, was eine vierte Ausführungsform des erfindungsgemäßen Verfahrens darstellt. In diesem Fall wird eine vordefinierte Geometrie der Leiterbahn 31, in Figur 5 als Quadrat gezeigt, verwendet, um ein individuelles Lotdepot 7 zu erstellen. Das Lotdepot 7 umfasst wiederum ein Gitter 8 mit mehreren Lotspeichern 9, die mit einem zweiten Lot 41 gefüllt sind. Die Lotspeicher 9 sind rund und sind innerhalb der Geometrie der Leiterbahn 31 gemäß der Theorie der dichtesten Packung angeordnet. Somit ist sichergestellt, dass eine maximale Anzahl von Lotspeichern auf der Leiterbahn 31 vorgesehen ist, sodass sich wiederum eine maximale Menge an zweitem Lot 41 auf der Oberfläche der Leiterbahn 31 verteilen kann.

In Figur 6 ist eine Leiterplatte 1 dargestellt, anhand derer das Integrieren des Vorgangs des Aufdickens der Leiterbahn 31 in das Anlöten von elektronischen Komponenten 5 aufzeigt. Die Leiterplatte 1 umfasst wiederum ein Substrat 2, wobei auf dem Substrat 2 ein Lötstopplack 6 aufgebracht ist, der an drei Stellen ausgespart ist. An einer ersten Stelle befindet sich eine Leiterbahn 31, an einer zweiten Stelle eine erste Anschlussfläche 32 und einer dritten Stelle eine zweite Anschlussfläche 33. In einem gemeinsamen Schritt wird nun ein zweites Lot 41 auf die Leiterbahn 31 aufgebracht, während ein erstes Lot 42 auf die erste Anschlussfläche 32 und ein, insbesondere zum ersten Lot 42 identisches, drittes Lot 43 auf die zweite Anschlussfläche 33 aufgebracht wird. Hier kann beispielsweise stets dasselbe Lot aus einem gemeinsamen Lotpastenvorrat verwendet werden. Anschließend wird die elektronische Komponente 5 auf die mit erstem Lot 42 und drittem Lot 43 bedeckten Anschlussflächen 32 und 33 aufgebracht. Schließlich wird das zweite Lot 41 auf der Leiterbahn 31, das erste Lot 42 auf der ersten Anschlussfläche 32 und das dritte Lot 43 auf der zweiten Anschlussfläche 33 gemeinsam erhitzt, sodass einerseits das zweite Lot 41 fest mit der Leiterbahn 31 verbunden wird, das erste Lot 42 auf der ersten Anschlussfläche 32 fest mit der elektrischen Komponente 5 und der ersten Anschlussfläche 32 verbunden wird, während das dritte Lot 43 fest mit der elektronischen Komponente 5 und der zweiten Anschlussfläche 33 verbunden wird. Insgesamt sind somit nicht mehr Schritte vonnöten, als für das Bestücken einer Leiterplatte mit elektronischen Komponenten vorgesehen seien müssen. Dennoch kann in vorteilhafterweise eine Aufdeckung der Leiterbahn 31 realisiert werden. Somit spart das erfindungsgemäße Verfahren Zeit und Kosten bei der Herstellung von Leiterplatten mit einer hohen Stromtragfähigkeit.

## Patentansprüche

1. Verfahren zum Herstellen einer Leiterplatte (1), umfassend die Schritte Bereitstellen eines Substrats (2),
Vorsehen von zumindest einer Leiterbahn (31) und zumindest einer Anschlussfläche (32) auf dem Substrat (2), und
Aufbringen zumindest eines ersten Lots (42) und zumindest einer elektronischen Komponente (5) auf die Anschlussfläche (32), **gekennzeichnet dadurch, dass**
auf oder an zumindest einen Teil der Leiterbahn (31) ein zweites Lot (41) aufgebracht wird, und
das erste Lot (42) auf der Anschlussfläche (32) und das zweite Lot (41) auf der Leiterbahn (32) gemeinsam bis mindestens zu einem Schmelzpunkt des ersten Lots (42) und des zweiten Lots (41) erhitzt wird,
wobei ein Querschnitt von zumindest einem Bereich der Leiterbahn (31) durch das zweite Lot (41) vergrößert wird.

2. Verfahren nach Anspruch 1, **dadurch gekennzeichnet, dass** das erste Lot (42) und/oder das zweite Lot (41) in Form einer Lötpaste auf die Anschlussfläche (32) und/oder auf die Leiterbahn (31) aufgebracht wird.

3. Verfahren nach einem der vorhergehenden Ansprüche, **dadurch gekennzeichnet, dass** ein Lötstopplack (6) auf die Leiterbahn (31) und/oder auf das Substrat (2) aufgebracht wird.

4. Verfahren nach Anspruch 3, **dadurch gekennzeichnet, dass** der Lötstopplack (6) vor dem Aufbringen des zweiten Lots (41) in dem zumindest einen Bereich der Leiterbahn (31) entfernt wird.

5. Verfahren nach einem der vorhergehenden Ansprüche, **dadurch gekennzeichnet, dass** das Aufbringen von zweitem Lot (41) auf die Leiterbahn (31) über ein Lotdepot (7) erfolgt.

6. Verfahren nach Anspruch 5, wobei das Lotdepot (7) ein mit zweitem Lot (41) gefülltes Gitter (8) umfasst, wobei das Gitter (8) eine Vielzahl von einzelnen Lotspeichern (9) definiert.

7. Verfahren nach Anspruch 6, wobei die Lotspeicher (9) kreisförmig oder polygonförmig ausgebildet sind und gemäß der Theorie der dichtesten Packung angeordnet sind.

8. Verfahren nach Anspruch 6, wobei die Lotspeicher (9) Geometrien aufweisen, die durch Voronoi-Tesselation bzw. Dirichlet-Zerlegung erzeugt werden.

9. Verfahren nach einem der Ansprüche 5 bis 8, wobei als Lotdepot (7) ein auf den zumindest einen Bereich der Leiterbahn (31) angepasste Teil einer vordefinierten Lotdepotvorlage (70) oder ein direkt für den zumindest einen Bereich der Leiterbahn (31) erstelltes Lotdepot (7) verwendet wird.

10. Verfahren nach einem der vorhergehenden Ansprüche, **dadurch gekennzeichnet, dass** das zweite Lot (41) derart auf die Leiterbahn (31) aufgebracht wird, dass die Fläche des Querschnitts der Kombination aus zweitem Lot (41) und Leiterbahn (31) zumindest das eineinhalbfache, insbesondere zumindest das zweifache, der Fläche des Querschnitts der Leiterbahn (31) beträgt.
